# EUROPÄISCHE PATENTANMELDUNG

(11) **EP 2 312 013 A1**
(43) Veröffentlichungstag der Anmeldung: **20.04.2011**
(21) Anmeldenummer: 10187035.0
(22) Anmeldetag: 08.10.2010
(51) Int. Cl.: C23C 16/04, C23C 16/40, F28F 19/02

(54) **Verfahren zur Beschichtung zumindest eines Teils eines Grundkörpers**

(30) Priorität: 13.10.2009 DE 102009049283
(71) Anmelder: Behr GmbH & Co. KG, 70469 Stuttgart (DE)
(72) Erfinder: Conrad, Nadine, 70469 Stuttgart (DE); Holler, Sebastian, 70825 Korntal-Münchingen (DE); Schaper, Jörg, 70806 Kornwestheim (DE); Holzmann, Frank, 90562 Herolsberg (DE)
(74) Vertreter: Grauel, Andreas

(57) **Zusammenfassung**

Verfahren zur Beschichtung zumindest eines Teils eines Grundkörpers (G,G',G"), insbesondere eines Wärmeübertragers, mittels in einem Beschichtungsofen (4, 4', 4") in einem CVD (Chemical Vapor Deposition) Prozess aktivierbarer Reaktiv-Komponente (5, 5', 6, jeweils eines ersten Gasstroms bzw. eines zweiten Gasstroms, wobei in einem ersten temperierten Gefäß (2, 2') Wasser als erste Reaktiv-Komponente (5, 5') und in einem zweiten temperierten Gefäß (3, 3') TEOS unterhalb der Siedetemperatur als zweite Reaktiv-Komponente (6, 6') vorliegt und ein Luft-Trägergasstrom vorgesehen ist, der sich in den Gefäßen (2, 2', 3, 3') mit der jeweiligen verdampfenden Reaktiv-Komponente (5, 5', 6, 6') sättigt und diese in den Beschichtungsofen (4, 4', 4") befördert.

## Beschreibung

Die Erfindung betrifft ein Verfahren zur Beschichtung zumindest eines Teils eines Grundkörpers. Die Erfindung betrifft des Weiteren eine Vorrichtung zur Durchführung des Verfahrens.

Zur Erhöhung der Kortosionsbeständigkeit von beispielsweise Aluminiumwärmeübertragern werden üblichenveise Passivierungsverfahren wie z.B. die Chromatierung eingesetzt. Viele dieser Verfahren besitzen den Nachteil, dass sie auf Oberflächen mit komplizierten dreidimensionalen Strukturen prinzipiell nicht oder nur schwierig appliziert werden können, keine gleichmäßige Schicht erzeugt werden kann oder der Wärmeübergang verschlechtert wird.

Aus dem Stand der Technik sind ferner verschiedene CVD-Verfahren (Chemical Vapor Deposition-Chemische Gasphasenabscheidung) bekannt. Beispielsweise offenbart die DE 19708808 A1 ein Verfahren und eine Vorrichtung zum Aufbringen von transparenten Schutzschichten auf Gegenstände sowie danach hergestellte Gegenstände. Offenbart wird u.a. ein Verfahren zum Aufbringen von Siliziufnoxidschichten mittels CVD. Dazu wird als Reaktivgas eine Verbindung aus Silizium und einer Monocarbonsäure (z.B. Siliziumtetraacetat) offenbart. Das Reaktivgas wird in einem vorgeschalteten Reaktor erzeugt und über ein Trägergas in einen Beschichtungsofen geleitet.

Die US 6167623 B1 offenbart ebenfalls ein Verfahren zum Aufbringen von Siliziumoxidschichten mittels CVD. Dazu werden der Beschichtungszone entweder gasförmiges TEOS (Tetraethylorthosilikat) und gasförmige Essigsäure und Wässerdampf oder gasförmiges TEOS und Wasserstoffperoxid in Sauerstoffträgergasstrom oder gasförmiges TEOS und flüssiges Wasserstoffperoxid mit gasförmigem Sauerstoff zugeführt und vermischt.

Nachteilig an den bekannten Beschichtungsverfahren ist jedoch der große anlagentechnische Aufwand zur Durchführung der Verfahren, So werden beispielsweise vorgeschaltet Reaktoren benötigt, in denen das eigentliche Reaktivgas aus der Grundsubstanz TEOS und Essigsäure erzeugt wird.

Es ist somit Aufgabe der vorliegenden Erfindung, ein einfacheres und kostengünstigeres Beschichtungsverfahren vorzuschlagen und gleichzeitig die Korrosionsbeständigkeit der Grundkörper/Bauteile zu verbessern.

Diese Aufgabe wird gelöst durch ein Verfahren mit den Merkmalen des Anspruchs 1, sowie einer Vorrichtung zur Durchführung des Verfahrens nach Anspruch 7 und/oder Anspruch 9. Vorteilhafte Ausgestattungen sind Gegenstand der Unteransprüche.

Die Aufgabe wird dadurch gelöst, dass bei einem Verfahren zur Beschichtung zumindest eines Teils eines Grundkorpers, insbesondere eines Wärmeübertragers, in einem Beschichtungsofen ein CVD (Chemical Vapor Deposition) Prozess mittels aktivierbarer Reaktiv-Komponenten jeweils eines ersten Gasstroms bzw eines zweiten Gasstroms durchgeführt wird, wobei in einem ersten temperierten Gefäß Wasser unterhalb der Siedetemperatur als erste Reaktiv-Komponente und in einem zweiten temperierten Gefäß TEOS als zweite Reaktiv-Komponente vorliegt und ein Luft-Tragergasstrom vorgesehen ist, der sich in den Gefäßen mit der jeweiligen verdampfenden Reaktiv-Komponente sättigt und diese in den Beschichtungsofen befördert. Dies hat den Vorteil, dass mit einfachen Mitteln eine Vereinfachung des Beschichtungsveffahrens erzielt werden kann, da nur TEOS und Wasser verwendet wird, anstatt beispielsweise eine weitere Substanz wie Essigsäure, weiche in einem vorgeschalteten Reaktionsgefäß angeordnet sein müssfe. Ferner weisen die mit dem erfindungsgemäßen Verfahren (TEOS und Wasser) beschichteten Grundkörper einen verbesserten Korrosionsschutz, verglichen beispielsweise mit solchen die mit TEOS und Essigsäure als Reaktivgas hergestellt wurden, auf.

Eine Ausführungsform sieht von dass bei dem Verfahren die Menge des Wassers in dem ersten temperierten Gefäß hinsichtlich einer katalytischen Wirkung und unter Berücksichtigung der bei der Reaktion freiwerdenden Wassermenge gewählt werden kann. Das Wasser wird dabei nur in katalytischer Menge benötigt, da in der im Beschichtungsofen stattfindenden Reaktion wieder Wasser gebildet wird.

Das Verfahren sieht ferner vor, dass die Einstellung der jeweiligen Konzentration der Reaktiv-Komponente in dem ersten temperierten Gefäß bzw. in dem zweiten temperierten Gefäß mittels der Temperatur in dem jeweiligen Gefäß erfolgen kann. Mit anderen Worten lässt sich über die Temperatur des Gefäßes die Konzentration der jeweiligen Stoffkomponente in der Gasphase einstellen. Dieser Verfahrensschritt bedeutet eine erheblich Vereinfachung im Verfahrensablauf.

Eine weitere bevorzugte Ausführungsform sieht vor, dass eine gesonderte, mischungsfreie Beförderung jeden Gasstromes von dem jeweiligen Gefäß zu dem Beschichtungsofen, im Sinne einer Parallelschaltung der Gasströme, vorgesehen sein kann. Dies bedeutet, dass die beiden Gasströme, mit gesättigtem TEOS und Wasser, jeweils in einer temperierten Leitung, die mindestens die Temperatur des jeweiligen Gefäßes aufweisen kann, in den Beschichtungsofen geleitet werden kann, ohne vorher vermischt zu werden.

Dabei kann ferner vorgesehen sein, dass das Verfahren eine Einstellung der Konzentration der ersten Reaktiv-Komponente in dem ersten temperierten Gefäß mittels dessen Temperatur und in dem zweiten temperierten Gefäß zusätzlich mittels dessen Temperatur vorsieht.

Eine weitere bevorzugte Ausführungsform sieht vor, dass die Beförderung des ersten Gasstromes in den zweiten Gasstrom vor dem Eintritt in den Beschichtungsofen im Sinne einer Hintereinanderschaltung der Gasströme erfolgen kann. Mit anderen Worten wird der Luft-Trägergasstrom hierbei in einem ersten Gefäß mit der ersten der beiden Reaktiv-Komponenten angereichert (Konzentrationseinsteilung über Temperatur). Der so gesättigte Luft-Trägergasstrom wird durch ein zweites Gefäß zur Anreicherung mit der zweiten Reaktiv-Komponente geleitet. Danach wird der Luft-Trägergasstrom in den Beschichtungsofen geleitet.

Bei einer Vorrichtung zur Durchführung des Verfahrens zur Beschichtung eines Grundkörpers ist die erfindungsgemäße Aufgabe dadurch gelöst, dass die Vorrichtung ein erstes, insbesondere Wasser aufnehmendes Gefäß und ein zweites, insbesondere TEOS, aufnehmendes Gesäß aufweist sowie mit jeweils einer von dem ersten Gefäß bzw. von dem zweiten Gefäß, im Sinne einer Parallelschaltung, zu dem Beschichtungsofen führenden, getrennten Förderleitung ausgestattet sein kann.

Eine andere bevorzugte Ausführungsform sieht vor, dass die Vorrichtung mit einem ersten, insbesondere Wasser aufnehmenden, Gefäß und einem zweiten, insbesondere TEOS aufnehmenden, Gefäß sowie mit jeweils von dem ersten Gefäß zu dem zweiten Gefäß, im Sinne einer Hintereinanderschaitung führenden, gemeinsamen Förderleitung ausgestattet sein kann.

Eine bevorzugte Ausführungsform sieht vor, dass die Vorrichtung insbesondere zur Beschichtung der Rohrinnenseite eines Wärmeübertragers ausgebildet ist, wobei der Grundkörper in eine Ringleitung eingebaut sein kann, in die ein Reaktivgemisch aus der ersten Reaktiv-Komponente und der zweiten Reaktiv-Komponente einleitbar ist.

Der Grundkörper ist dabei dicht in die Ringteitung eingebaut, wobei beispielsweise nur der Grundkörper auf die Beschichtungstemperatur (vorzugsweise 300-500°) erwärmt werden kann. Mit anderen Worten kann die Temperatur der Ringleitung höher als die Temperatur des jeweiligen temperieren Gefäßes sein, wobei nur der Grundkörper auf Beschichtungstemperatur erhitzt wird. Durch diesen Vorgang wird die Beschichtung lediglich am Grundkörper aufgebracht und somit die Beschichtungseffizienz deutlich gesteigerte

Bedingt durch die Abreaktion des Reaktivgasgemieches kann unter Umständen am Endbereich des durchströmten Grundkörpers weniger Reaktivgas für den Beschichtungsvorgang zur Verfügung stehen, was eventuell zu einer reduzierten bzw. ungleichmäßigen Beschichtungsdicke führen kann.

Eine Ausführungsform sieht daher vor, dass die Vorrichtung eine Ventil-Rohrteilanordnung aufweisen kann, derart, dass die Strömungsrichtung des Reaktiv-Gases in der Ringleitung umkehrbar ist, wobei die Beschichtungsdicke von einer Abreaktion des Reaktivgases - wie ansonsten bei nur einer Strömungsrichtung - unbeeinflusst bleibt. Somit lässt sich mit einfachen Mitteln eine vollständige und gleichmäßige Beschichtung des gesamten Grundkörpers realisieren.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung beschrieben sind. Dabei können die in den Ansprüchen und in der Beschreibung erwähnten Merkmale jeweils einzeln für sich oder in beliebiger Kombination erfindungswesentlich sein.

Es zeigen:
- Fig. 1: schematisches Beschichtungsschema mit geteiltem Luft- Trägergasstrom und paralleler Dampfsättigung;
- Fig. 2: schematisches Beschichtungsschema mit hintereinander- geschaltetem Luft-Trägergasstrom;
- Fig. 3: schematische Darstellung einer Ringleitung mit eingebautem Grund- körper;

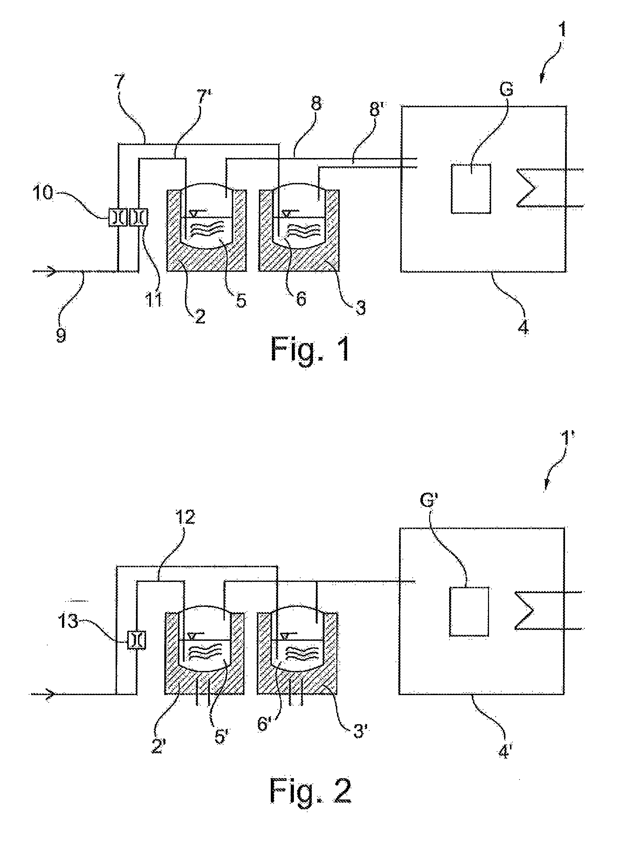

Fig. 1 zeigt ein schematisches Beschichtungsschema mit geteiltem Trägergasstrom und paralleler Dampfsättigung. Eine schematisch dargestellte Vorrichtung 1 umfasst zwei temperierte Gefäße 2 und 3 und einen schematisch dargestellten Beschichtungsofen 4. Die Vorrichtung 1 dient zum Beschichten eines im Beschtchtungsofen 4 angeordneten Grundkörpers G.

Im Gefäß 2 liegt eine erste Reaktiv-Komponente 5, insbesondere Wasser, vor und im Gefäß 3 liegt eine zweite Reaktiv-Komponente 6, insbesondere TEOS (Tetraethylorthosilikat), vor, wobei ein Luft-Trägergasstrom vorgesehen ist, der sich in den Gefäßen 2 und 3 mit der jeweiligen verdampfenden Reaktiv-Komponente 5 und 6 sättigt und in den Beschichtungsofen 4 befördert.

Die Vorrichtung 1 umfasst ferner mit jeweils einer von dem ersten Gefäß 2 bzw. von dem zweiten Gefäß 3, im Sinne einer Parallelschaltung, zu dem Beschichtungsofen 4 führende, getrennte Förderleitungen 7, 7' und 8, 8'. Über die Zufuhrleitung 9 wird ein Luft-Trägergasstrom über die Förderleitungen 7, 7' in die jeweiligen Gefäße 2 und 3 geleitet und dort mit der jeweiligen Reaktiv-Komponente 5 und 6 befrachtet. Der mit den Reaktiv-Komponenten 5 und 6 befrachtete Luft-Trägergasstrom wird anschließend über die Förderleitungen 8, 8' in den Beschichtunssofen 4 befördert, Im Verlauf der Förderleitungen 7, 7' sind zur Durchflussregulierung des unbefrachteten Luft-Trägergasstroms Ventile 10, 11 angeordnet.

Fig. 2 zeigt ein schematisches Beschichtungsschema mit hintereinandergeschaltetem Luft-Trägergasstrom. Eine schematisch dargestellte Vorrichtung 1' umfasst zwei temperierbare Gefäße 2' und 3' und einen schematisch dargestellten Beschichtungsofen 4'. Die Vorrichtung 1' dient zum Beschichten eines im Beachichtungsofen 4' angeordneten Grundkörpers G'.

Im Gefäß 2' liegt eine erste Reaktiv-Komponente 5', insbesondere Wasser, vor und im Gefäß 3' liegt eine zweite Reaktiv-Komponente 6', insbesondere TEOS (Tetraethylorthosilikat), vor, wobei ein Luft-Trägergasstrom vorgesehen ist, der sich in den Gefäßen 2' und 3' mit der jeweiligen verdampfenden Reaktiv-Komponente 5' und 6' sättigt und in den Beschichtungsofen 4' befördert wird.

Die Vorrichtung 1' umfasst ferner eine jeweils von dem ersten Gefäß 2' zu dem zweiten Gefäß 3', im Sinne einer Hintereinanderschaltung führende, gemeinsame Förderleitung 12. Der in der Förderleitung 12 verlaufende Luft-Trägergasstrom wird zuerst in das mit der ersten Reaktiv-Komponente 5' befüllte Gefäß 2' geleitet, dort mit der Reaktiv-Komponente 5' befrachtet und anschließend in das mit der zweiten Reaktiv-Komponente, 6' befüllte Gefäß 3' geleitet, und dort mit der zweiten Reaktiv-Komponente 6' befrachtet.

Danach wird der mit den Reaktiv-Komponenten 5' und 6' befrachtete Luft-Trägergasstrom zum weiteren Beschichtungsvorgang in den Beschichtungofen 4' geleitet. Im Verlauf der Förderleitung 12 ist zur Durchflussregulierung des unbefrachteten Luft-Trägergasstroms ein Ventil 13 angeordnet.

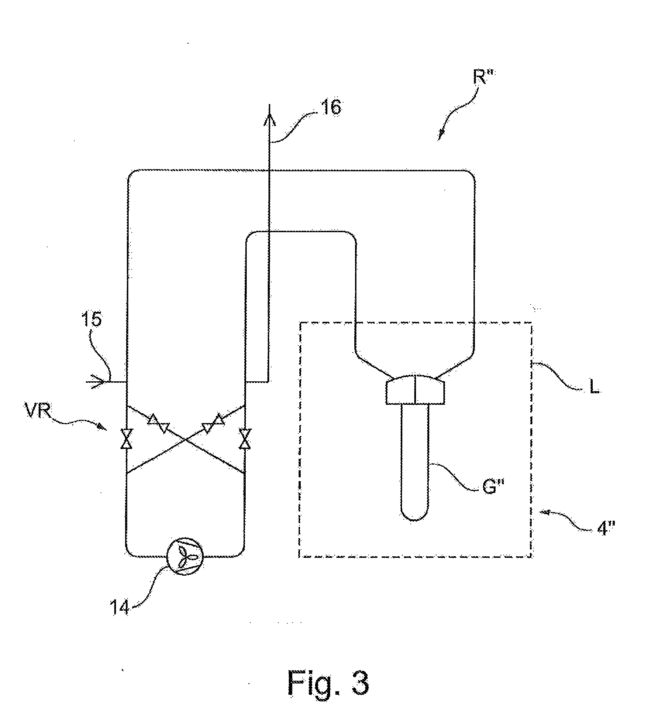

Fig. 3 zeigt eine schematische Darstellung einer Ringleitung R mit in die Ringleitung R eingebautem Grundkörper G", wobei die gestrichelte Linie L schematisch einen Beschichtungsofen 4" darstellen soll, in dem die Ringleitung R bereichsweise bzw. der Grundkörper G" vollständig angeordnet ist. Der Grundkörper G" ist dicht in die Ringleitung R eingebaut, wobei in die Ringleitung R ein Reaktivgemisch aus einer ersten Reaktiv-Komponente und einer zweiten Reaktiv-Kompotiente über den Reaktivgas-Einlass 15 einleitbar ist.

Bei dem hier gezeigten Grundkörper G" handelt es sich um einen Wärmeübertrager.

In der Ringleitung R ist eine Ventil-Rohrteilanordnung VR vorgesehen, mit der die Strömungsrichtung des Reaktiv-Gases in der Ringleitung R umkohrbar ist, wobei die Beschichtungsdicke von einer Abreaktion des Reaktivgases - wie ansonsten bei nur einer Strömungsnchtung - unbeeinflusst bleibt, Ferner sind in der Ringleitung R ein Gebläse 14, ein Reaktivgas-Einlass 15 sowie ein Abgasauslass 16 vorgesehen.

## Patentansprüche

1. Verfahren zur Beschichtung zumindest eines Teils eines Grundkörpers (G,G',G"), insbesondere eines Wärmeübertragers, mittels in einem Beschichtungsofen (4, 4', 4") in einem CVD (Chemical Vapor Deposition) Prozess aktivierbare Reaktiv-Komponente (5, 5', 6, 6') jeweils eines ersten Gasstroms bzw. eines zweiten Gasstroms, wobei in einem ersten temperierten Gefäß (2 2') TEOS (Tetraethylortnosilikat) als erste Reaktiv-Komponente (5, 5') und in einem zweiten temperierten Gefäß (3, 3') Wasser unterhalb der Siedetemperatur als zweite Reaktiv-Komponente (6, 6') vorliegt und ein Luft-Trägergasstrom vorgesehen ist, der sich in den Gefäßen (2, 2', 3, 3') mit der jeweiligen verdampfenden Reaktiv-Komponente (5, 5', 6, 6') sättigt und diese in den Beschichtungsofen (4, 4', 4") befördert.

2. Verfahren nach Anspruch 1, wobei die Menge des Wassers in dem ersten temperierten Gefäß (2, 2') hinsichtlich einer katalytische Wirkung und unter Berücksichtigung der bei der Reaktion freiwerdenden Wassermenge gewählt wird.

3. Verfahren nach Anspruch 1 und/oder 2, mit einer Einstellung der jeweiligen Konzentration der Reaktiv-Komponente (5, 5', 6, 6') in dem ersten temperierten Gefäß (2, 2') bzw. in dem zweiten temperierten Gefäß (3, 3') mittels der Temperatur in dem jeweiligen Gefäß (2, 2', 3, 3').

4. Verfahren nach Anspruch 3, mit einer gesonderten, mischungsfreien Beförderung jeden Gasstromes von dem jeweiligen Gefäß (2, 3) zu dem Beschichtungsofen (4), im Sinne einer Parallelschaltung der Gasströme.

5. Verfahren nach Anspruch 1 und/oder 2, mit einer Einstellung der Konzentration der ersten Reaktiv-Komponente (5, 5') in dem ersten temperierten Gefäß (2,2') mittels dessen Temperatur und in dem zweiten temperierten Gefäß (3, 3') zusätzlich mittels dessen Temperatur.

6. Verfahren nach Anspruch 5, mit einer Beförderung des ersten Gasstromes in den zweiten Gasstrom vor dem Eintritt in den Beschichtungsofen (4') im Sinne einer Hintereinanderschaltung der Gasströme.

7. Vorrichtung zur Durchführung des Verfahrens nach zumindest einem der Ansprüche 1 bis 5, mit einem ersten, insbesondere Wasser aufnehmenden Gefäß (2) und einem zweiten, insbesondere TEOS, aufnehmenden Gefäß (3) sowie mit jeweils einer von dem ersten Gefäß (2) bzw. von dem zweiten Gefäß (3), im Sinne einer Parallelschaltung, zu dem Beschichtungsofen (4) führenden, getrennten Förderieltung (7, 7', 8, 8').

8. Vorrichtung zur Durchführung des Verfahrens nach zumindest einem der Ansprüche 1 bis 6, mit einem ersten, insbesondere Wasser aufnehmenden, Gefäß (2') und einem zweiten, insbesondere TEOS aufnehmenden, Gefäß (3') sowie mit jeweils von dem ersten Gefäß (2') zu dem zweiten Gefäß (3'), im Sinne einer Hintereinanderschaltung führenden, gemeinsamen Förderleitung (12).

9. Vorrichtung zur Durchführung des Verfahrens nach Anspruch 1, insbesondere zur Beschichtung der Rohrinnenseite eines Wärmeübeitragers wobei der Grundkörper (G") in eine Ringleitung (R) eingebaut ist, in die ein Reaktivgemisch aus der ersten Reaktiv-Komponente (5, 5') und der zweiten Reaktiv-Komponente (6, 6') einleitbar ist.

10. Vorrichtung nach Anspruch 9, wobei die Temperatur der Ringleitung (R) höher als die Temperatur des jeweiligen temperierten Gefäßes (2, 2', 3, 3') und nur der Grundkörper (G") auf Beschichtungstemperatur erhöht ist.

11. Vorrichtung nach Anspruch 9 und/oder 10, mit einer Ventil-Rohrteilanordnung (VR), derart, dass die Strömungsrichtung des Reaktiv-Gases in der Ringleitung (R) umkehrbar ist, derart, dass die Beschichtungsdicke von einer Abreaktion des Reaktivgases - wie ansonsten bei nur einer Strömungsnchtung - unbeeinflusst bleibt.
